# EUROPEAN PATENT APPLICATION

(11) **EP 3 828 304 A1**
(43) Date of publication of application: **02.06.2021**
(21) Application number: 19306537.2
(22) Date of filing: 29.11.2019
(51) Int. Cl.: C23C 14/08, C03C 17/245, C23C 14/58

(54) **THIN LAYER DEPOSITION PROCESS**

(71) Applicant: SAINT-GOBAIN GLASS FRANCE, 92400 Courbevoie (FR)
(72) Inventor: BRUNEAU, Bastien, 75014 Paris (FR); YEH, Li-Ya, 52511 Geilenkirchen (DE); HAGEN, Jan, 53123 Bonn (DE); ZIMMERMANN, Roberto, 42653 Solingen (DE)
(74) Representative: Saint-Gobain Recherche

(57) **Abstract**

The invention relates to a process for obtaining a coated article comprising a substrate coated with a photocatalytic coating, said process comprising: depositing a coating comprising an outermost layer based on titanium oxide on said substrate, thus obtaining a coated substrate; and crystallizing said layer based on titanium oxide by submitting the coated substrate to UV radiations; as well as to a substrate coated with a photocatalytic coating obtained in therefrom.

## Description

The invention relates to a process for obtaining a coated article comprising a substrate coated with a photocatalytic coating as well as to a substrate coated with a photocatalytic coating obtained in therefrom, in particular for self-cleaning applications.

A process commonly employed on the industrial scale for the deposition of thin layers, in particular on a glass or glass-ceramic substrate, is the sputtering process, in particular enhanced by a magnetic field, referred to in this case as the "magnetron" process. In this process, a plasma is created under high vacuum in the vicinity of a target comprising the chemical elements to be deposited. The active entities of the plasma, by bombarding the target, tear off said elements, which are deposited on the substrate, forming the desired thin layer. This process is termed "reactive" when the layer consists of a material resulting from a chemical reaction between the elements torn from the target and the gas contained in the plasma. The major advantage of this process lies in the possibility of depositing, on the same line, a very complex stack of layers by successively making the substrate run under various targets, generally in one and the same device.

Thin layers based on titanium oxide have the property of being self-cleaning, by facilitating the degradation of organic compounds under the action of ultraviolet radiation (photocatalysis phenomenon) and the removal of mineral soiling (dust) under the action of water runoff. Titanium dioxide crystallized in anatase phase is much more effective in terms of degradation of organic compounds than amorphous titanium dioxide or even titanium dioxide crystallized in rutile or brookite phase. However, titanium oxide layers deposited by magnetron process are amorphous or marginally crystallized. An activation step is thus required for crystallizing the titanium oxide layer and obtaining the expected photocatalytic activity. This activation of titanium oxide layer is commonly performed by a thermal process such as tempering. More recently, rapid heat treatments have been proposed for obtaining photocatalytic titanium oxide layers. For example, WO 2009/136110 describes process for crystallizing a titanium oxide layer comprising a crystallization step using IR laser radiation. Since titanium oxide does not absorb IR radiations, it is however necessary in this case to include a radiation absorbing layer in the vicinity of the titanium oxide layer. The absorbing layer absorbs efficiently the energy from the radiations and transmits this energy to the titanium oxide layer allowing its crystallization. Another method described in WO 2011/039488 comprises depositing an intermediate metal, nitride or carbide layer, and an oxidizing this intermediate layer using a rapid heat treatment, such as laser radiation. Such a process thus resulting in oxide layer may be used for obtaining photocatalytic titanium oxide layers.

However, it appears that the rapid heat treatments described above may not allow reaching the expected photocatalytic activity levels. Therefore, there is a need for a rapid heat treatment process that can provide photocatalytic coating having improved efficiency.

The present invention thus provides a process for obtaining a coated article comprising a substrate coated with a photocatalytic coating, said process comprising:
- depositing a coating comprising an outermost layer based on titanium oxide on said substrate, thus obtaining a coated substrate; and
- crystallizing said layer based on titanium oxide by submitting the coated substrate to UV radiations,
wherein the layer based on titanium oxide is essentially free of nitrogen, and the power density of the UV radiations is from 50 to 400 J/cm².

Contrary to what was generally considered, it has indeed been found that the known rapid heat treatments using IR radiations and/or forming a titanium oxide layer through oxidation of and intermediate layer, such as a metallic, nitride, or oxynitride layer, mostly result in rutile crystalline phase. Surprisingly, the crystallization step of the invention comprising submitting a titanium oxide layer to UV radiations results in a titanium oxide-based photocatalytic layer crystallized in anatase phase. Consequently, the photocatalytic coating obtained with the process of the present invention has significantly improved photocatalytic activity.

The process according to the invention comprises a first step of depositing a coating comprising an outermost layer based on titanium oxide on said substrate. By the terms "on" and "under" when related to the relative position of one element (layer, coating) to another, it is meant that said element is more distant from or closer to, respectively, the substrate than the other one. It is not meant that said elements are directly contacting each other, without excluding this possibility. In particular, additional elements may be present between said elements. On the contrary, the expression "direct contact" "directly on" or "directly under" when related to the relative position of one element to another means that no additional element is disposed between said elements. In the context of the present application, the expression "based on" when referring to the composition of a layer means that said layer comprises more than 80%, preferably more than 90%, or even more than 95% by weight of said material. Said layer may be essentially made of said material.

The substrate may be organic or inorganic such as a glass substrate, a glass-ceramic substrate or a polymeric organic substrate. The thickness of the substrate may be from 0.1 mm to 19 mm, preferably from 0.5 to 9 mm, from 2 to 8 mm, or from 4 to 6 mm. The preferred polymeric organic materials are polycarbonate (PC), polymethylmethacrylate (PMMA), or polyethylene terephthalate (PET). The substrate is preferably in sheet form. It may be flat, curved, or even flexible. It has advantageously at least one dimension of at least 1 m, preferably at least 2 m, or even at least 3 m. The glass is preferably of soda-lime-silica type but it may be of any other type such as borosilicate or alumino-borosilicate type. The glass substrate is preferably of a float glass, meaning that it is obtained by a process which consists in pouring the molten glass onto a bath of molten tin ("float" bath). In this case, the layer to be treated can be deposited both on the "tin" face and on the "atmosphere" face of the substrate. The terms "atmosphere" and "tin" faces are understood to mean the faces of the substrate which have respectively been in contact with the atmosphere prevailing in the float bath and in contact with the molten tin. The tin side contains a small superficial amount of tin which has diffused into the structure of the glass. The glass substrate can also be obtained by rolling between two rolls, which makes it possible in particular to print patterns on its surface. The substrate is preferably transparent, and may be colourless (it may then be a clear or extra-clear glass) or coloured, for example blue, green, grey or bronze.

The coating may be a single layer or a multilayer coating. Accordingly, when the coating is a single layer, the layer based on titanium oxide may be in direct contact with the substrate. Alternatively, in certain embodiments, other layers, such as a barrier layer to alkali metals, a UV reflecting layer, or a UV reflecting layer stack, or other functional layers, may be deposited between the substrate and the layer based on titanium oxide.

The layer based on titanium oxide has typically a thickness from 5 to 50 nm, preferably 8 to 20 nm. It may be doped, for example with an atoms selected from transition metal, carbon and fluorine. However, it preferably consists of titanium oxide, optionally sub-stoichiometric, e.g. TiOₓ wherein x is 1.8, or 1.9 to 2, but preferably stoichiometric, i.e. TiO₂. In any case, the layer based on titanium oxide is essentially free of nitrogen, meaning that it comprises less than 5 at.%, preferably less than 2 at.%, more preferably less than 1 at.%. In general, no other layer is deposited on the layer based on titanium oxide so that the photocatalytic layer obtained at the end of the process according to the invention is the last layer of the coating in contact with the atmosphere. In particular, the coating preferably does not comprise a temporary absorbing layer, in particular over the layer based on titanium oxide. The expression "temporary absorbing layer" refers more particularly to a layer absorbing IR and/or visible radiations and is either eliminated or becomes transparent to visible radiations after treatment with such IR and/or visible radiations.

A barrier layer to alkali metals may be provided between the substrate and the layer based on titanium oxide for protecting the titanium oxide-based photocatalytic layer from alkali ion pollution, in particular in case the coated substrate is intended to be submitted to tempering. The barrier layer to alkali metals has typically a thickness from 5 to 100 nm, preferably from 10 to 70 nm. It is preferably based on silicon oxide, silicon nitride or silicone oxynitride. When present, the barrier layer to alkali metals is preferably in direct contact with the substrate.

In order to improve the crystallization of the layer based on titanium oxide in anatase crystalline phase, a crystallization promoting layer may be provided directly under the layer based on titanium oxide. The crystallization promoting layer has typically a thickness from 1 to 50 nm. The crystallization promoting layer may be based on zirconium oxide, BaTiO₃ or SrTiO₃. Such crystallization promoting layers are described for example in WO 02/40417 or WO 2005/040058.

A UV reflective layer may be provided under the layer based on titanium oxide for improving both the crystallization efficiency of the layer during the process of the invention. The UV reflecting layer has typically a thickness from 5 to 100 nm, preferably from 10 to 70 nm. It is preferably based on zinc oxide. Alternatively, the UV reflecting layer may be a multilayer stack comprising alternating high-index layers, such as silicon nitride, and low-index layers, such as silicon oxide. When present, the UV reflecting layer is preferably directly under the layer based on titanium oxide or the crystallization promoting layer.

Other functional layers well known in the art, such as anti-reflective stacks based on alternation of dielectric layers having low and high refractive index, anti-condensation stacks based on transparent conductive oxide layers, or solar control stacks based in IR reflective metal layers, may be deposited between the substrate and the layer based on titanium oxide.

The coating according to the present invention may be deposited by any process, resulting in particular predominantly in amorphous or nanocrystallized layers, such as the magnetron sputtering process, the plasma-enhanced chemical vapor deposition (PECVD) process, the vacuum evaporation process or the sol-gel process. However, it is preferably a "dry" film, containing no aqueous or organic solvent, as opposed to a "wet" film obtained for example by the sol-gel process. It is preferably obtained by sputtering process, in particular magnetron sputtering.

The deposition of the layer based on titanium oxide is preferably performed at a relatively low temperature, e.g., a temperature of not more than 100 °C, preferably not more than 80 °C, or even ambient temperature. During industrial implementation of magnetron sputtering, the substrate generally remains at ambient temperature or is slightly heated (less than 80 °C).

The method according to the invention also comprises a crystallization step comprising a treatment of the coated substrate wherein the coating is irradiated with UV radiations. The substrate is heated relatively little during the crystallization step. The temperature of the surface opposite to the coating remains generally below 100 °C. The temperature of the coating comprising the layer based on titanium oxide advantageously remains below 600 °C at every point during the exposition to UV radiations. Advantageously, the coating comprising the layer based on titanium oxide reaches a temperature of at least 100 °C during the crystallization step.

In the context of the present invention, UV radiations relate to wavelengths from 150 to 400 nm, preferably from 250 to 380 nm. The power density (P) of the UV radiations is from 0.1 to 6 kW/cm², preferably from 0.5 to 5 kW/cm². UV radiations may be radiations emitted from a UV source, or UV radiations device, selected from UV laser, UV LED and UV flash lamps. The UV radiations are preferably emitted from UV laser.

The UV laser can be selected from broadband, multichromatic, or monochromatic UV laser, although monochromatic UV laser is preferred. UV radiations can be generated by common lasers. The UV radiation can in particular result from a laser chosen from:
- excimer lasers, for example an argon fluoride laser (wavelength of 193 nm);
- solid-state lasers having a YAG (yttrium aluminum garnet) or YVO4 matrix, which are in particular doped with neodymium or with ytterbium, and which are coupled to a frequency tripler or quadrupler; a Nd:YAG or Nd:YVO4 laser can thus be coupled to a frequency tripler, in order to produce laser radiation, the wavelength of which is 355 nm, or also to a frequency quadrupler, the radiation obtained then having a wavelength of 266 nm;
- fiber lasers doped with ytterbium.

Other lasers emitting in the ultraviolet region are, for example, argon lasers or ion (xenon, krypton) lasers, dye lasers, free-electron lasers, cerium-doped solid-state lasers or gallium nitride (GaN) laser diodes. UV radiations are preferably generated by a solid-state laser. Compared to other lasers, such as excimer lasers, UV-solid-state lasers are particularly easy to integrate into the method according to the invention and are easy to use. The laser radiation may be pulsed, the pulse duration being typically from 1 fs to 1 µs, preferably from 1 to 100 ns, and the pulse frequency from 1 kHz to 1 MHz. In this case, the power density is to be considered as the time-averaged power-density (P) defined as P=E^{∗}f wherein E is the energy per pulse and f is the pulse frequency.

The UV laser may be punctiform or linear. When the laser beam is punctiform, a system for scanning the surface of the coated substrate is required. However, the laser radiation is preferably emitted by at least one laser beam forming a line, called a "laser line", which simultaneously irradiates all or part of the width of the substrate. The laser beam is typically shaped into a laser line using optics. The thickness of the line is preferably between 0.01 and 1 mm. The length of the line is typically between 5 mm and 1 m, or even up to 3 m or more.

The form of the laser beam may be selected depending on the substrate form. In the case of 3D substrates for example, such as plastic glazing with organic substrates, the laser can be installed on a robot or a multi-axis system in order to move the punctiform or linear laser beam of the UV laser for treating the free-form surfaces, with the linear laser beam having, for example, a line width of less than 10 mm. In case of flat substrates, such as glass substrates, in particular large flat glass sheets (having width of more than 3 m), e.g. "jumbo" size glass sheets (6 m x 3.21 m) leaving *float* processes, irradiation with a laser line itself very long (> 3 m) is advantageous for scanning at once the entire width of the coated substrate.

The laser line simultaneously irradiating all or part of the width of the substrate may be made up of a single line (in which case it irradiates the entire width of the substrate), or a plurality of elementary lines either combined together to form a line or optionally separate from each other. When a plurality of elementary lines is used, each line is preferably arranged so that the entire area of the coated substrate is treated. The or each line is preferably arranged essentially perpendicularly to the run direction of the substrate.

In order to irradiate the entire surface of coated substrate, a relative movement is generally generated between the laser line and the coated substrate. The substrate may thus be moved, especially so as to run translationally in front of a stationary laser line, generally under the laser line - but may also run above said laser line. This embodiment is particularly advantageous for a continuous process. Alternatively, the coated substrate may be stationary and the laser may be moved. Preferably, the difference between the respective speeds of the coated substrate and the laser is greater than or equal to 0,5 meter per minute, or 1 meters per minute or even 4, or 6 meters per minute, and may be up to 30 or 20 meter per minute so as to ensure a high treatment rate.

When the laser line is moving, a system is provided for moving the laser, located above or beneath the substrate. The duration of the treatment is regulated by the run speed of the laser line.

When the substrate is moving, generally in translation, it may be moved using any mechanical conveying means, for example belts, rollers or trays running translationally. The conveying system is used to control and regulate the run speed. If the substrate is made of a flexible polymeric organic material, it may be moved using a film advance system in the form of a succession of rollers.

The laser may also be moved so as to adjust its distance from the substrate, which may be useful in particular, but not only, when the substrate is bent. The laser beam is indeed preferably focused onto the coating comprising the layer based on titanium oxide so that the latter is located at a distance of less than or equal to 1 mm from the focal plane. This adjustment may be automatic, in particular regulated using a distance measurement upstream of the treatment.

Of course, all relative positions of the substrate and the laser are possible provided that the coating can be suitably irradiated. The substrate is generally positioned horizontally, but it may also be positioned vertically, or at any possible inclination. When the substrate is positioned horizontally, the coating is generally facing the top side and the laser positioned so as to irradiate the top side of the coated substrate. The laser may also irradiate the underside of the coated substrate, the coating facing in this case the lower side of the substrate. The substrate support system, and optionally the substrate conveying system when the substrate is moving, must in such a case let the radiations pass into the zone to be irradiated. This possible for example by using conveying rollers. Since the rollers are separate entities, the laser beam can pass into a zone located between two successive rollers.

The UV radiations device, for example the UV laser, may be integrated into a coating deposition line, for example a magnetron sputtering line or a chemical vapor deposition (CVD) line, especially a plasma-enhanced (PECVD) line, under vacuum or at atmospheric pressure (AP-PECVD). In general, the deposition line includes substrate handling devices, a deposition unit, optical control devices and stacking devices. For example, the substrates run on conveyor rollers, passing through each device or each unit one after the other.

The UV radiations device, for example the UV laser, is preferably located just after the deposition unit, for example at the exit of the deposition unit. The coated substrate may thus be treated in line after the coating has been deposited, at the exit of the deposition unit and before the optical control devices, or after the optical control devices and before the substrate stacking devices.

The UV radiations device may also be integrated into the deposition unit. For example, the UV laser may be introduced into one of the chambers of a sputtering deposition unit, especially in a chamber in which the atmosphere is rarefied, especially at a pressure between 10-6 mbar and 10-2 mbar. The UV laser may also be placed outside the deposition unit, but so as to treat a substrate located inside said unit. For this purpose, a UV-transparent window, through which the laser beam passes, is provided to treat the coating within the deposition chamber.

Whether the UV radiations device is outside the deposition unit or integrated thereinto, these "in-line" processes are preferable to a process involving off-line operations, which would require to stack the coated substrates between the deposition step and the crystallization step.

However, processes involving off-line operations may have an advantage when the crystallization step according to the invention is carried out in a different place from where the deposition step is performed. The UV radiation device may therefore be integrated into lines other than the coating deposition line. For example, it may be integrated into a multiple glazing (in particular double or triple glazing) manufacturing line or into a laminated glazing manufacturing line. In those cases, the crystallization step according to the invention is preferably carried out before the multiple glazing or laminated glazing is produced.

As already mentioned, the use of UV radiations during the crystallization step results in a titanium oxide-based photocatalytic layer crystallized in anatase phase. The expressions "crystallized in anatase phase" or "partially crystallized in anatase phase" mean that the titanium oxide-based photocatalytic layer is mainly crystallized in anatase phase, i.e. at least 50 wt.%, preferably at least 70 wt.%, or event at least 90 wt.% of the titanium oxide is crystallized in anatase phase. In addition, it has been found that heat treatments, in particular tempering, of such titanium oxide-based photocatalytic layer obtained according to the process of the present invention does not affect adversely the photocatalytic efficiency of the coating. On the contrary, with other known rapid heat treatments using IR radiations and/or forming a titanium oxide layer through oxidation of an intermediate metal, nitride or oxynitride layer, the obtained photocatalytic layers, in addition to not being crystallized in an anatase phase, show lower photocatalytic efficiency or even lose their photocatalytic properties after being submitted to heat treatment.

Accordingly, the process according to the present invention may further comprise, after the crystallization step, a heat treatment step. When the substrate is inorganic, such as a glass substrate, a glass-ceramic substrate or a ceramic substrate, the heat treatment step may be a tempering step. During this tempering step, the coated substrate is generally submitted to a heat treatment at high temperature, e.g. of at least 500 °C, preferably at least 550 °C, and generally up to not more than 750 °C, preferably not more than 700 °C. This heat treatment may be carried out during a glass bending process. Organic substrate may also be subjected to a heat treatment step. However, in that case, lower temperatures should be used in order to avoid melting or softening of the substrate. In such a case, the temperature of the heat treatment will depend on the nature of the organic substrate. It may be from 100 °C, or 150 °C and up to 250 °C or 200 °C.

The present invention also relates to a coated article, obtainable by the process as defined above, comprising a substrate coated with a coating comprising an outermost titanium oxide-based photocatalytic layer, wherein the substrate is not a tempered glass said titanium oxide is at least partially crystallized in the anatase phase. The coating has preferably a photocatalytic activity of more than 20 µg.mL⁻¹,min⁻¹, preferably more than 25 µg.mL⁻¹.min⁻¹, more preferably more than 30 µg.mL⁻¹.min⁻¹. The photocatalytic activity is measured by contacting an aqueous solution of methylene blue having an initial concentration Cᵢ with the coated surface of the coated substrate in an hermetic cell, the coated surface forming the bottom of the cell, exposing the coated surface with UV light for 30 minutes, measuring the final concentration C_{f} of the aqueous solution of methylene blue after exposure, and calculating the photocatalytic activity, expressed in µg.mL⁻¹.min⁻¹, corresponding to the formula (Cᵢ - C_{f}) / 30.

The substrate may be, as defined above in relation with the process of the invention, organic or inorganic such as a glass substrate, a glass-ceramic substrate or a polymeric organic substrate. The substrate is preferably a non-tempered inorganic glass substrate, an organic glass substrate or an organic polymeric substrate, more preferably the substrate is a non-tempered glass substrate.

The titanium oxide-based photocatalytic layer of the coated article typically results from the crystallization of a layer based on titanium oxide according to the process of the present invention. Accordingly, apart from the crystallization form of titanium oxide, the titanium oxide-based photocatalytic layer has essentially the same composition as the layer based on titanium oxide as defined in relation to the process of the present invention. In particular, the titanium oxide-based photocatalytic layer preferably consists of optionally sub-stoichiometric titanium oxide.

The coating of the coated article may also comprise, as already described above, a barrier layer to alkali metals, a UV reflecting layer and/or other functional layers between the titanium oxide-based photocatalytic layer and the substrate.

The coated article according to the invention is preferably incorporated into a glazing such as a vehicle glazing or a building glazing. The glazing can be single or multiple (in particular double or triple), i.e. a glazing comprising several glass sheets providing a gas-filled space. The glazing can also be laminated and/or tempered and/or hardened and/or curved.

The face of the substrate opposite the photocatalytic coating, or where appropriate a face of another substrate of the multiple glazing, may be coated with another functional layer or with a stack of functional layers. It may in particular be layers or stacks having a thermal function, in particular solar-protection or low-emissivity layers or stacks. It may also be a mirror layer, in particular based on silver. It may finally be a lacquer or an enamel intended to opacify the glazing in order to make a wall cladding panel therefrom, known as spandrel glass. The spandrel glass is positioned on building walls next to non-opacified glazing in order to obtain walls that are entirely glazed and homogeneous from an aesthetic point of view.

The invention is illustrated in more details in following non-limiting examples.

### EXAMPLES

Samples of coated glass substrates comprising an outermost layer based on titanium oxide have been exposed to different type of radiations. Comparative example C1 is a glass substrate coated with the following stack: glass//SiO₂ (40 nm)/Ti (5 nm) treated with a IR laser having a wavelength of 980 nm. C2, I1 and I2 are glass substrates coated with the following stack: glass//SiO₂ (40 nm)/TiO₂ (11 nm). I1 and 12, corresponding to examples according to the invention, were treated with a ns-pulsed UV laser (pulse width <20 ns) having a wavelength of 343 nm, whereas comparative example C2 was treated with a IR laser having a wavelength of 980 nm. C3 and C4 are glass substrates coated with the following stack: glass//SiO₂ (40 nm)/TiON (10 nm). They have been treated with the same UV laser and same conditions than I1 and I2 respectively. C0 is an uncoated glass substrate used as a reference.

The photocatalytic activity is then measured by contacting an aqueous solution of methylene blue having an initial concentration Cᵢ with the coated surface of the coated substrate in an hermetic cell, the coated surface forming the bottom of the cell; exposing the coated surface with UV light (centered at 350 nm and with a power of 40 W/m²) for 30 minutes; measuring the final concentration C_{f} of the aqueous solution of methylene blue after exposure; and calculating the photocatalytic activity, expressed in µg.mL⁻¹.min⁻¹, corresponding to the formula (Cᵢ - C_{f}) / 30.

The results are shown in the following table:

| Sample | C0 | C1 | C2 | C3 | C4 | I1 | I2 |
|---|---|---|---|---|---|---|---|
| Outermost treated layer | - | Ti | TiO₂ | TiON | TiON | TiO₂ | TiO₂ |
| Treatment | - | IR laser | IR laser | UV laser | UV laser | UV laser | UV laser |
| Power density (W/cm²) | - | 60 | 60 | 3.5 | 3.5 | 3.5 | 3.5 |
| Line speed (m/min) | - | 6 | 6 | 1.2 | 6 | 1.2 | 6 |
| Crystallinity | amorph. TiO₂ | TiO₂ rutile | amorph. TiO₂ | no TiO₂ or amorph. TiO₂ | no TiO₂ or amorph. TiO₂ | TiO₂ anatase | TiO₂ anatase |
| Kb after treatment (µg.mL⁻¹.min⁻¹) | 10 | 18 | 10 | 10 | 10 | 33 | 32 |
| Kb after treatment and tempering (µg.m^{- 1}.min⁻¹) | 10 | 10 | 30 | 10 | 10 | 20 | 19 |

Samples I1 and I2 comprising a titanium oxide layer treated with UV radiation show Kb values above 30, much higher than for sample C1 wherein a titanium metal is treated with IR radiations, sample C2 wherein titanium oxide is treated with IR radiations, and samples C3 and C4 wherein titanium oxynitride is treated with UV radiations. This is due to the fact that anatase phase could only be obtained through treatment of a titanium oxide layer with UV radiation. Treatment of sample C1 with IR radiation results in TiO₂ layer in rutile phase, whereas the Raman spectroscopy analyses of samples C2 after treatment with IR radiations, and C3 and C4 after treatment with UV radiations, showed no peak corresponding to TiO₂, meaning, for sample C2, that the TiO2 layer remains amorphous, and for samples C3 and C4, either that the layer remained TiON or that the TiO₂ formed is amorphous. In addition, after tempering samples C1, C2, C3 and C4 do not show higher Kb value than the uncoated glass substrate C0. On the contrary, samples I1 an 12 show higher Kb value, meaning that they still exhibit photocatalytic activity after tempering.

## Claims

1. A process for obtaining a coated article comprising a substrate coated with a coating comprising a photocatalytic layer, said process comprising:
- depositing a coating comprising an outermost layer based on titanium oxide on said substrate, thus obtaining a coated substrate; and
- crystallizing said layer based on titanium oxide by submitting the coated substrate to UV radiations,
wherein the layer based on titanium oxide is essentially free of nitrogen.

2. Process according to claim 1, wherein the substrate is selected from glass substrates, glass-ceramic substrates or polymeric organic substrates.

3. Process according to claim 1 or 2, wherein the power density of the UV radiations is from 0.1 to 6 kW/cm².

4. Process according to any one of claims 1 to 3, wherein the UV radiations are radiations emitted from a UV source selected from UV lasers, UV LED and UV flash lamps.

5. Process according to any one of claims 1 to 4, wherein the UV radiation are radiations emitted from UV lasers forming a laser line simultaneously irradiating the entire width of the substrate.

6. Process according to any one of claims 1 to 5, wherein the layer based on titanium oxide is deposited by sputtering process.

7. Process according to any one of claims 1 to 6, wherein the layer based on titanium oxide has a thickness from 5 to 20 nm.

8. Process according to any one of claims 1 to 7, wherein the layer based on titanium oxide is a TiOx layer with 1.8 ≤x≤ 2, preferably a TiO₂ layer.

9. Process according to any one of claims 1 to 8, wherein the coating does not comprise a temporary absorbing layer.

10. Process according to any one of claims 1 to 9, wherein the process further comprises a tempering step after the crystallization step.

11. A coated article, obtainable by the process as defined in any one of claims 1 to 10, comprising a substrate coated with a coating comprising an outermost titanium oxide-based photocatalytic layer, wherein the substrate is not tempered glass and said titanium oxide is at least partially crystallized in the anatase phase.

12. The coated article according to claim 10, wherein said coating has a photocatalytic activity of more than 20 µg.mL⁻¹.min⁻¹, wherein the photocatalytic activity is measured by contacting an aqueous solution of methylene blue having an initial concentration Cᵢ with the coated surface of the coated substrate in an hermetic cell, the coated surface forming the bottom of the cell, exposing the coated surface with UV light for 30 minutes, measuring the final concentration C_{f} of the aqueous solution of methylene blue after exposure, and calculating the photocatalytic activity, expressed in µg.mL⁻¹.min⁻¹, corresponding to the formula (Cᵢ - C_{f}) / 30.

13. The coated article according to claim 11 or 12, where the substrate is selected form a non-tempered inorganic glass substrate, an organic glass substrate or an organic polymeric substrate.
